# EUROPEAN PATENT APPLICATION

(11) **EP 4 790 316 A1**
(43) Date of publication of application: **12.08.2026**
(21) Application number: 24892459.9
(22) Date of filing: 22.10.2024
(51) Int. Cl.: F23D 14/22

(54) **SEMICONDUCTOR PROCESS APPARATUS AND IGNITION CHAMBER THEREOF**

(30) Priority: 15.11.2023 CN 202311521156
(71) Applicant: Beijing NAURA Microelectronics Equipment Co., Ltd., Beijing 100176 (CN)
(72) Inventor: KONG, Xiangtian, Beijing 100176 (CN); WANG, Lika, Beijing 100176 (CN)
(74) Representative: Cohausz & Florack
(86) International application number: PCT/CN2024/126335
(87) International publication number: WO 2025/103090

(57) **Abstract**

The present disclosure provides a semiconductor process apparatus and an ignition chamber thereof. The ignition chamber includes a chamber body and a delivery pipeline, the chamber body includes an inner wall of a combustion chamber and an outer wall of the combustion chamber surrounding the inner wall of the combustion chamber, a diluent gas channel is formed between the inner wall of the combustion chamber and the outer wall of the combustion chamber, the outer wall of the combustion chamber is connected to a diluent gas pipeline communicating with the diluent gas channel, the inner wall of the combustion chamber is connected to a combustible gas pipeline and a combustion-supporting gas pipeline, and the combustible gas pipeline and the combustion-supporting gas pipeline both communicate with an interior of the combustion chamber; and the delivery pipeline is configured to be connected to a process chamber of the semiconductor process apparatus, the delivery pipeline is connected to the outer wall of the combustion chamber and communicates with the diluent gas channel, and the inner wall of the combustion chamber is provided with an outlet port, which communicates the interior of the combustion chamber with an interior of the delivery pipeline. A combustible gas and a combustion-supporting gas react in the combustion chamber to generate a reaction product. A diluent gas can be heated by heat generated during reaction, so that a temperature of the heated diluent gas is higher than a dew point temperature of the reaction product, which can prevent the reaction product from condensing and avoid a problem of excessive particles.

## Description

### TECHNICAL FIELD

The present disclosure relates to the field of semiconductor manufacturing, and in particular, to a semiconductor process apparatus and an ignition chamber thereof.

### BACKGROUND

When a wet oxygen oxidation process apparatus operates, an external ignition device performs heating with a heater to enable reaction of hydrogen and oxygen in an ignition chamber, so as to supply pure high-temperature water vapor to a process chamber for generating an oxide film on a surface of a silicon wafer. With the progress of the market, process requirements are increased accordingly, which desires growth of an oxide film with small thickness, uniform film quality, and few particles on the surface of the silicon wafer.

In order to meet the process requirements, a proper amount of nitrogen is introduced into the ignition chamber during combustion of hydrogen and oxygen to dilute the water vapor, thereby enabling generation of an oxide film with uniform film quality, small thickness, and few particles. In the existing technology, condensed water is generated in a pipeline used for the introduction of nitrogen due to a diffusion effect of the high-temperature water vapor, resulting in a problem of excessive particles.

Therefore, how to avoid the problem of excessive particles caused by the condensed water is an urgent technical problem to be solved by those of ordinary skill in the art.

### SUMMARY

The present disclosure aims to solve at least one of the technical problems in the existing technology, and provides a semiconductor process apparatus and an ignition chamber thereof, which can heat a diluent gas with heat generated by reaction of a combustible gas and a combustion-supporting gas to increase a temperature of the diluent gas, thereby avoiding the problem of excessive particles caused by condensed water.

In order to achieve the objective of the present disclosure, there is provided an ignition chamber for a semiconductor process apparatus, including a chamber body and a delivery pipeline, the chamber body includes an inner wall of a combustion chamber and an outer wall of the combustion chamber surrounding the inner wall of the combustion chamber, a diluent gas channel is formed between the inner wall of the combustion chamber and the outer wall of the combustion chamber, the outer wall of the combustion chamber is connected to a diluent gas pipeline communicating with the diluent gas channel, the inner wall of the combustion chamber is connected to a combustible gas pipeline and a combustion-supporting gas pipeline, and the combustible gas pipeline and the combustion-supporting gas pipeline both communicate with an interior of the combustion chamber; and
the delivery pipeline is configured to be connected to a process chamber of the semiconductor process apparatus, the delivery pipeline is connected to the outer wall of the combustion chamber and communicates with the diluent gas channel, and the inner wall of the combustion chamber is provided with an outlet port, which communicates the interior of the combustion chamber with an interior of the delivery pipeline.

In some embodiments, the combustible gas pipeline is located inside the combustion-supporting gas pipeline, and a combustion-supporting gas flow channel is formed between the combustion-supporting gas pipeline and the combustible gas pipeline, and communicates with the interior of the combustion chamber.

In some embodiments, a length of the combustible gas pipeline is greater than a length of the combustion-supporting gas pipeline, an end of the combustible gas pipeline which is located outside the combustion-supporting gas pipeline is a closed end, and a portion of the combustible gas pipeline which is located outside the combustion-supporting gas pipeline is provided on a peripheral side with a combustible gas connecting pipe for connection to a combustible gas source.

In some embodiments, the inner wall of the combustion chamber is provided with a combustible gas inlet and combustion-supporting gas inlets, the combustible gas inlet communicates the combustible gas pipeline with the interior of the combustion chamber, the combustion-supporting gas inlets communicate the interior of the combustion chamber with the combustion-supporting gas pipeline, a number of the combustion-supporting gas inlets is more than two, and the combustion-supporting gas inlets are disposed around the combustible gas inlet.

In some embodiments, the combustible gas inlet and the combustion-supporting gas inlets are all located on a side of the inner wall of the combustion chamber away from the delivery pipeline.

In some embodiments, the combustion-supporting gas pipeline is located inside the diluent gas pipeline, and a diluent gas flow channel is formed between the diluent gas pipeline and the combustion-supporting gas pipeline, and communicates with the diluent gas channel.

In some embodiments, a length of the combustion-supporting gas pipeline is greater than a length of the diluent gas pipeline, an end of the combustion-supporting gas pipeline which is located outside the diluent gas pipeline is a closed end, and a portion of the combustion-supporting gas pipeline which is located outside the diluent gas pipeline is provided on a peripheral side with a combustion-supporting gas connecting pipe for connection to a combustion-supporting gas source.

In some embodiments, the diluent gas pipeline is provided with a diluent gas connecting pipe on a peripheral side away from the combustion chamber for connection to a diluent gas source.

In some embodiments, the outlet port is connected to an outlet pipe, the outlet pipe is located inside the delivery pipeline, an outer diameter of the outlet pipe is less than an inner diameter of the delivery pipeline, and a length of the outlet pipe is less than a length of the delivery line.

In some embodiments, the inner diameter of the delivery pipeline is 1.5 to 2 times the outer diameter of the outlet pipe.

In some embodiments, the ignition chamber further includes a heater and a thermal insulation device, the thermal insulation device and the heater form a heating and insulation chamber together, and the chamber body is located in the heating and insulation chamber; and the heater is disposed at a connection where the combustible gas pipeline and the combustion-supporting gas pipeline are connected to the chamber body, and the combustible gas pipeline, the combustion-supporting gas pipeline, and the chamber body are partially located inside the heater.

The present disclosure further provides a semiconductor process apparatus, including a process chamber and the ignition chamber provided herein, and the ignition chamber communicates with the process chamber through the delivery pipeline.

The present disclosure has the following beneficial effects.

The ignition chamber provided herein is used for the semiconductor process apparatus, and includes the chamber body and the delivery pipeline, the chamber body includes the inner wall of the combustion chamber and the outer wall of the combustion chamber surrounding the inner wall of the combustion chamber, the diluent gas channel is formed between the inner wall of the combustion chamber and the outer wall of the combustion chamber, the outer wall of the combustion chamber is connected to the diluent gas pipeline communicating with the diluent gas channel, the inner wall of the combustion chamber is connected to the combustible gas pipeline and the combustion-supporting gas pipeline, and the combustible gas pipeline and the combustion-supporting gas pipeline both communicate with the interior of the combustion chamber; and the delivery pipeline is configured to be connected to the process chamber of the semiconductor process apparatus, the delivery pipeline is connected to the outer wall of the combustion chamber and communicates with the diluent gas channel, and the inner wall of the combustion chamber is provided with the outlet port, which communicates the interior of the combustion chamber with the interior of the delivery pipeline.

During a process, a combustible gas and a combustion-supporting gas react in the combustion chamber to generate a reaction product. Heat generated during reaction can heat a diluent gas in the diluent gas channel, and the reaction product and the diluent gas are then mixed in the delivery pipeline and delivered into the process chamber. Since a temperature of the heated diluent gas is higher than a dew point temperature of the reaction product, the reaction product can be prevented from condensing, and the problem of excessive particles can be avoided.

The present disclosure further provides the semiconductor process apparatus including the above ignition chamber, and the semiconductor process apparatus has the above advantages.

### BRIEF DESCRIPTION OF DRAWINGS

FIG. 1 is a schematic structural diagram of a semiconductor process apparatus according to the present disclosure;
FIG. 2 is a schematic structural diagram of a chamber body of FIG. 1;
FIG. 3 is a partial enlarged view of the chamber body of FIG. 2;
FIG. 4 is a cross-sectional view of the chamber body of FIG. 2.

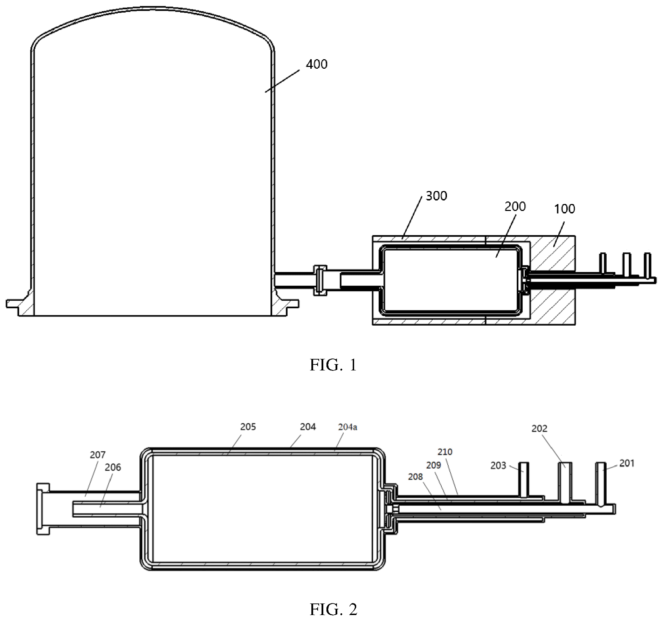

Description of reference numerals in FIG. 1 to FIG. 4:
100-heater; 200-chamber body; 201-combustible gas connecting pipe; 202-combustion-supporting gas connecting pipe; 203-diluent gas connecting pipe; 204-outer wall of combustion chamber; 204a-diluent gas channel; 205-inner wall of combustion chamber; 206-outlet pipe; 207-delivery pipeline; 208-combustible gas pipeline; 209-combustion-supporting gas pipeline; 209a-combustion-supporting gas flow channel; 210-diluent gas pipeline; 210a-diluent gas flow channel; 211-combustible gas inlet; 212-combustion-supporting gas inlet; 300-thermal insulation device; 400-process chamber.

### DETAIL DESCRIPTION OF EMBODIMENTS

In order to enable those of ordinary skill in the art to better understand the technical solutions in the present disclosure, a semiconductor process apparatus and an ignition chamber thereof provided in the present disclosure are described in detail below with reference to the drawings.

The present disclosure provides an ignition chamber for a semiconductor process apparatus. As shown in FIG. 1 and FIG. 2, the ignition chamber includes a chamber body 200 and a delivery pipeline 207. The chamber body 200 includes an inner wall 205 of a combustion chamber and an outer wall 204 of the combustion chamber surrounding the inner wall 205 of the combustion chamber, with a diluent gas channel 204a formed therebetween. The inner wall 205 of the combustion chamber is connected to a combustible gas pipeline 208 and a combustion-supporting gas pipeline 209, an inner cavity enclosed by the inner wall 205 of the combustion chamber is an interior of the combustion chamber, the combustible gas pipeline 208 and the combustion-supporting gas pipeline 209 both communicate with the interior of the combustion chamber, and a combustible gas and a combustion-supporting gas enter the combustion chamber through the combustible gas pipeline 208 and the combustion-supporting gas pipeline 209 respectively, and react inside the combustion chamber to generate a product. The delivery pipeline 207 is configured to be connected to a process chamber 400 of the semiconductor process apparatus, and the inner wall 205 of the combustion chamber is provided with an outlet port communicating the interior of the combustion chamber with an interior of the delivery pipeline 207. The outlet port is located on a side of the inner wall 205 of the combustion chamber facing the delivery pipeline 207, one end of the delivery pipeline 207 communicates with the outlet port to communicate the interior of the combustion chamber with the delivery pipeline 207, and the other end of the delivery pipeline 207 is configured to be connected to the process chamber 400 and communicate with an interior of the process chamber 400, so that the reaction product may be delivered into the process chamber 400 through the delivery pipeline 207. In an exemplary implementation of the present disclosure, the combustible gas is hydrogen, the combustion-supporting gas is oxygen, and the reaction product is water vapor. The combustible gas and the combustion-supporting gas may be selected as needed, which is not limited herein.

The outer wall 204 of the combustion chamber is connected to a diluent gas pipeline 210, which communicates with the diluent gas channel 204a. The delivery pipeline 207 is connected to the outer wall 204 of the combustion chamber, and communicates with the diluent gas channel 204a. A diluent gas enters the delivery pipeline 207 through the diluent gas pipeline 210 and the diluent gas channel 204a, dilutes the reaction product in the delivery pipeline 207 to an appropriate concentration, and enters the process chamber 400 together with the reaction product. In general, the diluent gas does not react with the reaction product, and does not affect a process. In an exemplary implementation of the present disclosure, the diluent gas is nitrogen. Other diluent gases may be selected as needed, which is not limited herein.

In some embodiments, the outer wall 204 of the combustion chamber and the delivery pipeline 207 may be an integrally formed structural component, which can improve structural strength and service life of the ignition chamber. Certainly, the outer wall 204 of the combustion chamber may be connected to the delivery pipe 207 by welding or other means, which is not limited herein.

In the present embodiment, heat may be generated during the reaction of the combustible gas and the combustion-supporting gas inside the combustion chamber, and may heat the diluent gas in the diluent gas channel 204a, so that a temperature of the diluent gas is higher than a dew point temperature of the reaction product; moreover, the diluent gas may heat the delivery pipeline 207, so as to avoid condensation of the reaction product on an inner wall of the delivery pipeline 207, and prevent the reaction product from condense into liquid drops during delivery into the process chamber 400, thereby avoiding the problem of excessive particles.

In some embodiments, the ignition chamber further includes a heater 100, which may be disposed around at least part of the chamber body 200 to heat the combustible gas and the combustion-supporting gas for the reaction inside the combustion chamber. As shown in FIG. 1, the heater 100 may be disposed at a connection where the combustible gas pipeline 208 and the combustion-supporting gas pipeline 209 are connected to the chamber body 200, and the combustible gas pipeline 208, the combustion-supporting gas pipeline 209, and the chamber body 200 are partially located inside the heater 100. The heater 100 heats the combustible gas and the combustion-supporting gas in the combustible gas pipeline 208, the combustion-supporting gas pipeline 209, and the chamber body 200 to enable the combustible gas and the combustion-supporting gas to reach ignition points and react in the combustion chamber. In addition, the diluent gas pipeline 210 may be partially located inside the heater 100, and the heater 100 may heat the diluent gas in the diluent gas pipeline 210 while heating the combustible gas and the combustion-supporting gas. On this basis, the heater 100 may further heat the diluent gas in the diluent gas channel 204a. Thus, the diluent gas is heated twice while flowing through the diluent gas pipeline 210 and the diluent gas channel 204a in sequence, so that the temperature of the diluent gas may be further increased, and it is ensured that the temperature of the diluent gas is higher than the dew point temperature of the reaction product. Certainly, the heater 100 may adopt other structures, which is not limited herein.

In some embodiments, the ignition chamber further includes a thermal insulation device 300, which may be disposed around part of the chamber body 200 to reduce heat dissipation of the chamber body 200. As shown in FIG. 1, the thermal insulation device 300 and the heater 100 form a heating and insulation chamber together, and the chamber body 200 is located in the heating and insulation chamber. The thermal insulation device 300 can provide thermal insulation for the diluent gas in the diluent gas channel 204a, reduce heat dissipation of the diluent gas, increase heat of the diluent gas, and reduce the risk of condensation of the reaction product in the diluent gas. In addition, the thermal insulation device 300 can further reduce heat release to the outside of the ignition chamber, and reduce the risk of damage to other components caused by high temperature.

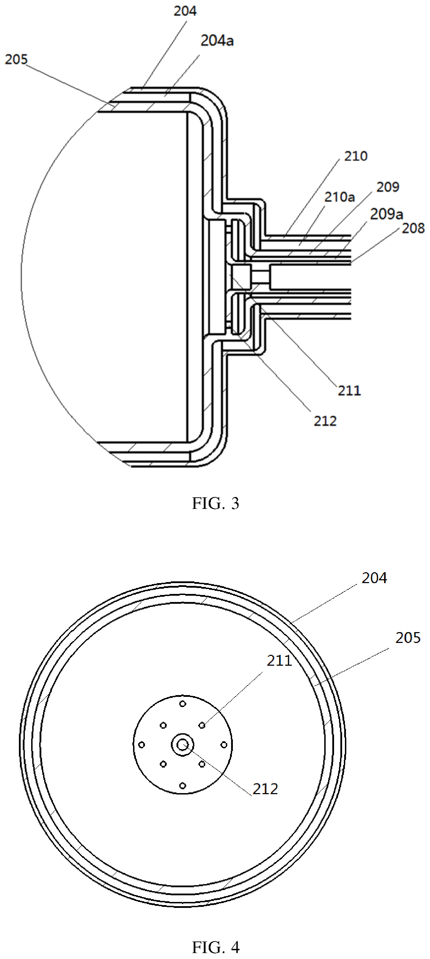

In some embodiments, the combustible gas pipeline 208 is located inside the combustion-supporting gas pipeline 209. Further, the combustible gas pipeline 208 and the combustion-supporting gas pipeline 209 are coaxially disposed, for example. As shown in FIG. 2 and FIG. 3, a combustible gas flow channel is formed inside the combustible gas pipeline 208, and a combustion-supporting gas flow channel 209a is formed between the combustion-supporting gas pipeline 209 and the combustible gas pipeline 208. The inner wall 205 of the combustion chamber is provided with a combustible gas inlet 211 and combustion-supporting gas inlets 212, the combustible gas inlet 211 communicates the interior of the combustion chamber with the combustible gas flow channel inside the combustible gas pipeline 208, and the combustion-supporting gas inlets 212 communicate the interior of the combustion chamber with the combustion-supporting gas flow channel 209a. The combustible gas and the combustion-supporting gas enter the combustion chamber through the combustible gas inlet 211 and the combustion-supporting gas inlets 212, respectively. The combustible gas pipeline 208 and the combustion-supporting gas pipeline 209 form a double-layer pipe structure, which can save space and improve structural strength of pipe fittings. Certainly, distribution of the combustible gas pipeline 208 and the combustion-supporting gas pipeline 209 may also be configured as needed, for example, the combustible gas pipeline 208 may be disposed outside the combustion-supporting gas pipeline 209, which is not limited herein.

In some embodiments, the combustible gas inlet 211 and the combustion-supporting gas inlets 212 are all located on a side of the inner wall 205 of the combustion chamber away from the delivery pipeline 207. As shown in FIG. 2, the combustible gas inlet 211 and the combustion-supporting gas inlets 212 are all far away from the outlet port, so that a sufficient reaction space is provided for the combustible gas and the combustion-supporting gas, the combustible gas and the combustion-supporting gas can fully react inside the combustion chamber, and the generated reaction product can be discharged through the outlet port. Thus, the risk that the combustible gas and the combustion-supporting gas do not fully react when entering the process chamber 400 is reduced, and process reliability is improved. In addition, a heating temperature of the heater 100 may be reasonably set, so as to increase reaction speed of the combustible gas and the combustion-supporting gas, and enable full reaction of the combustible gas and the combustion-supporting gas.

In some embodiments, the number of the combustion-supporting gas inlets 212 is more than two, and the combustion-supporting gas inlets 212 are disposed around the combustible gas inlet 211. In an implementation illustrated by FIG. 4, the number of combustion-supporting gas inlets 212 is 8, and the combustion-supporting gas inlets 212 are evenly distributed around the combustible gas inlet 211, for example, in a square pattern. By disposing more than two combustion-supporting gas inlets 212 around the combustible gas inlet 211, contact area of the combustion-supporting gas and the combustible gas can be increased when the combustion-supporting gas flows into the combustion chamber, thereby accelerating the reaction speed. A diameter of each combustion-supporting gas inlet 212 may be smaller than that of the combustible gas inlet 211, and the combustible gas and the combustion-supporting gas can fully react through control on flow rates of the combustible gas and the combustion-supporting gas, so as to avoid an influence of the redundant combustible gas or the redundant combustion-supporting gas on the process. Certainly, the combustion-supporting gas inlets 212 may be distributed in other ways, such as circular distribution; and the number of combustion-supporting gas inlets 212 is not limited thereto.

In some embodiments, the chamber body 200 may be cylindrical. The combustible gas inlet 211 and the outlet port may be respectively located at midpoints of two end surfaces of the chamber body 200, and may be, for example, coaxially disposed with the chamber body 200, and the combustion-supporting gas inlets 212 may be disposed around the combustible gas inlet 211. Thus, the combustible gas and the combustion-supporting gas can fully react inside the combustion chamber. Certainly, a shape of the chamber body 200 and locations of the combustible gas inlet 211 and the outlet port may be set based on user needs, which is not limited herein.

In some embodiments, a length of the combustible gas pipeline 208 is greater than that of the combustion-supporting gas pipeline 209. One end of the combustible gas pipeline 208 which is located outside the combustion-supporting gas pipeline 209 is a closed end, and a portion of the combustible gas pipeline 208 which is located outside the combustion-supporting gas pipeline 209 is provided on a peripheral side with a combustible gas connecting pipe 201 for connection to a combustible gas source. As shown in FIG. 2, the end of the combustible gas pipeline 208 away from the chamber body 200 extends out of the combustion-supporting gas pipeline 209 to form a first connector. The end of the combustible gas pipeline 208 away from the chamber body 200 is provided with a first end plate for sealing the end of the combustible gas pipeline 208, that is, forming the closed end, so as to ensure sealing performance of the combustible gas flow channel inside the combustible gas pipeline 208. The combustible gas connecting pipe 201 is connected to the first connector (i.e., the portion of the combustible gas pipeline 208 which is located outside the combustion-supporting gas pipeline 209) on the peripheral side, the combustible gas connecting pipe 201 is configured to be connected to the combustible gas source, and the combustible gas may enter the combustible gas flow channel inside the combustible gas pipeline 208 through the combustible gas connecting pipe 201. Certainly, in practical applications, the end of the combustible gas pipeline 208 may be an open end, that is, the first end plate is omitted, and the combustible gas connecting pipe 201 is hermetically connected to the open end.

In some embodiments, the combustion-supporting gas pipeline 209 is located inside the diluent gas pipeline 210. Further, the combustion-supporting gas pipeline 209 is disposed coaxially with the diluent gas pipeline 210, for example. As shown in FIG. 2 and FIG. 3, a diluent gas flow channel 210a is formed between the diluent gas pipeline 210 and the combustion-supporting gas pipeline 209. The diluent gas flow channel 210a communicates with the diluent gas channel 204a, and the diluent gas may flow into the diluent gas channel 204a through the diluent gas flow channel 210a. The combustible gas pipeline 208, the combustion-supporting gas pipeline 209, and the diluent gas pipeline 210 may form a triple-layer pipe structure, which can further reduce occupied space of the pipelines, improve structural strength of the pipelines, and reduce the risk of damage to the pipelines. Certainly, the present disclosure is not limited thereto. In practical applications, any two of the combustible gas pipeline 208, the combustion-supporting gas pipeline 209, and the diluent gas pipeline 210 may form a two-layer pipe structure, and the remaining one is separately disposed; or each of the three pipelines is separately disposed.

In some embodiments, the length of the combustion-supporting gas pipeline 209 is greater than that of the diluent gas pipeline 210, an end of the combustion-supporting gas pipeline 209 which is located outside the diluent gas pipeline 210 is a closed end, and a portion of the combustion-supporting gas pipeline 209 which is located outside the diluent gas pipeline 210 is provided on a peripheral side with a combustion-supporting gas connecting pipe 202 for connection to a combustion-supporting gas source. As shown in FIG. 2, the end of the combustion-supporting gas pipeline 209 away from the chamber body 200 extends out of the diluent gas pipeline 210 to form a second connector. The end of the combustion-supporting gas pipeline 209 away from the chamber body 200 is provided with an annular second end plate, an inner ring of the second end plate is hermetically connected to the combustible gas pipeline 208, and an outer ring of the second end plate is hermetically connected to the combustion-supporting gas pipeline 209, so that the end of the combustion-supporting gas pipeline 209 is sealed, that is, the closed end is formed. The combustion-supporting gas connecting pipe 202 is connected to the second connector (i.e., the portion of the combustion-supporting gas pipeline 209 which is located outside the diluent gas pipeline 210) on the peripheral side, the combustion-supporting gas connecting pipe 202 is configured to be connected to the combustion-supporting gas source, and the combustion-supporting gas may enter the combustion-supporting gas pipeline 209 through the combustion-supporting gas connecting pipe 202. With the second end plate, the end of the combustion-supporting gas pipeline 209 away from the chamber body 200 can be sealed, so that sealing performance of the combustion-supporting gas flow channel 209a can be ensured. On this basis, in the embodiment in which the length of the combustible gas pipeline 208 is greater than that of the combustion-supporting gas pipeline 209, the combustible gas pipeline 208 can be spatially avoided by connecting the combustion-supporting gas connecting pipe 202 to the second connector on the peripheral side.

In some embodiments, an end of the diluent gas pipeline 210 away from the combustion chamber is a closed end, and the diluent gas pipeline 210 is provided with a diluent gas connecting pipe 203 on a peripheral side. As shown in FIG. 2, the end of the diluent gas pipeline 210 away from the chamber body 200 is provided with an annular third end plate, an inner ring of the third end plate is hermetically connected to the combustion-supporting gas pipeline 209, and an outer ring of the third end plate is hermetically connected to the diluent gas pipeline 210 , so that the end of the diluent gas pipeline 210 is sealed, that is, the closed end is formed. The diluent gas connection pipe 203 may be perpendicular to the diluent gas pipeline 210 and connected to the diluent gas pipeline 210 on the peripheral side of the diluent gas pipeline 210. The diluent gas connecting pipe 203 is configured to be connected to a diluent gas source, and the diluent gas may enter the diluent gas flow channel 210a through the diluent gas connecting pipe 203. With the third end plate, the end of the diluent gas pipeline 210 away from the combustion chamber can be sealed, so that sealing performance of the diluent gas flow channel 210a can be ensured. On this basis, in the embodiment in which the length of the combustion-supporting gas pipeline 209 is greater than that of the diluent gas pipeline 210, the combustion-supporting gas pipeline 209 can be spatially avoided by connecting the diluent gas connecting pipe 203 to the diluent gas pipeline 210 on the peripheral side of the diluent gas pipeline 210.

In some embodiments, the combustible gas pipeline 208 is nested inside the combustion-supporting gas pipeline 209 and is welded and fixed to the inner wall 205 of the combustion chamber, and the combustion-supporting gas pipeline 209 is nested inside the diluent gas pipeline 210 and is welded and fixed to the inner wall 205 of the combustion chamber. The inner wall 205 of the combustion chamber is welded and fixed to the combustion-supporting gas pipeline 209, and the outer wall 204 of the combustion chamber surrounds the inner wall 205 of the combustion chamber and is welded and fixed to the diluent gas pipeline 210.

In some embodiments, the outlet port is connected to an outlet pipe 206, the outlet pipe 206 is located inside the delivery pipeline 207, and an outer diameter of the outlet pipe 206 is less than an inner diameter of the delivery pipeline 207. Further, the outlet pipe 206 and the delivery pipeline 207 are, for example, coaxially disposed, and a length of the outlet pipe 206 is less than that of the delivery pipeline 207. As shown in FIG. 2, the high-temperature reaction product generated by the combustible gas and the combustion-supporting gas enters the delivery pipeline 207 through the outlet pipe 206, and the diluent gas may be introduced into the delivery pipeline 207 through a flow channel between the delivery pipeline 207 and the outlet pipe 206 and mixed with the reaction product of the combustible gas and the combustion-supporting gas in the delivery pipeline 207.

Illustratively, the inner diameter of the delivery pipeline 207 is 1.5 to 2 times the outer diameter of the outlet pipe 206. Certainly, the inner diameter of the delivery pipeline 207 and the outer diameter of the outlet pipe 206 may be set as needed, which is not limited herein.

With the outlet pipe 206 connected to the outlet port, due to the smaller inner diameter of the outlet pipe 206, the flowing of the reaction product in the outlet pipe 206 is affected by the Venturi effect, resulting in an increased flow rate and a decreased pressure. The reaction product may still be kept at a relatively high flow rate after entering the delivery pipeline 207, so that a pressure in a region through which the reaction product flows is lower than that of the nearby diluent gas. The diluent gas flows towards the reaction product under the action of a pressure difference and is mixed with the reaction product, and finally, the diluent gas is driven by the reaction product to flow towards the process chamber 400. Under the effect, the reaction product can drive the diluent gas to flow towards the process chamber 400 quickly, and can be prevented from flowing reversely into the diluent gas channel 204a, which eliminates the problem of condensation of the reaction product at the source.

In some embodiments, the outlet pipe 206 and the inner wall 205 of the combustion chamber may be an integrally formed structure, and the delivery pipeline 207 and the outer wall 204 of the combustion chamber may be an integrally formed structure.

In some embodiments, the chamber body 200, the delivery pipeline 207, the outlet pipe 206, and the triple-layered pipe structure are all made of quartz which can withstand high temperatures, has high structural strength, and can meet process requirements. Certainly, other materials such as ceramics may be selected as needed, which is not limited herein.

The present disclosure further provides a semiconductor process apparatus, including a process chamber 400 and the ignition chamber provided in the above embodiments.

In some embodiments, the process chamber 400 is provided with a connecting flange, and the delivery pipeline 207 of the ignition chamber is connected to the connecting flange, and communicates the ignition chamber with the process chamber 400. A combustible gas and a combustion-supporting gas react inside the ignition chamber, and generate a reaction product. A diluent gas dilutes the reaction product, and is delivered into the process chamber 400 together with the reaction product through the delivery pipeline 207 and the connecting flange, and the reaction product participates in a process in the process chamber 400. Structures of other parts of the semiconductor process apparatus can be found in the existing technology, and will not be described here.

The diluent gas can be heated during reaction of the combustible gas and the combustion-supporting gas in the ignition chamber, so that a temperature of the diluent gas is increased, and it is ensured that the temperature of the diluent gas is higher than a dew point temperature of the reaction product during delivery, which prevents the reaction product from condensing during the delivery, and avoid the problem of excessive particles. The diluted reaction product enters the process chamber 400 in a gaseous state and reacts in the process chamber 400, thereby forming a uniform film on a surface of a wafer. Thus, process level and product performance are improved.

It should be understood that the above implementations are just exemplary implementations adopted to illustrate the principle of the present disclosure, and the present disclosure is not limited thereto. Various modifications and improvements can be made by those of ordinary skill in the art without departing from the spirit and essence of the present disclosure, and those modifications and improvements are also considered to fall within the scope of the present disclosure.

## Claims

1. An ignition chamber for a semiconductor process apparatus, comprising a chamber body and a delivery pipeline, wherein the chamber body comprises an inner wall of a combustion chamber and an outer wall of the combustion chamber surrounding the inner wall of the combustion chamber, a diluent gas channel is formed between the inner wall of the combustion chamber and the outer wall of the combustion chamber, the outer wall of the combustion chamber is connected to a diluent gas pipeline communicating with the diluent gas channel, the inner wall of the combustion chamber is connected to a combustible gas pipeline and a combustion-supporting gas pipeline, and the combustible gas pipeline and the combustion-supporting gas pipeline both communicate with an interior of a combustion chamber; and
the delivery pipeline is configured to be connected to a process chamber of the semiconductor process apparatus, the delivery pipeline is connected to the outer wall of the combustion chamber and communicates with the diluent gas channel, and the inner wall of the combustion chamber is provided with an outlet port, which communicates the interior of the combustion chamber with an interior of the delivery pipeline.

2. The ignition chamber of claim 1, wherein the combustible gas pipeline is located inside the combustion-supporting gas pipeline, and a combustion-supporting gas flow channel is formed between the combustion-supporting gas pipeline and the combustible gas pipeline, and communicates with the interior of the combustion chamber.

3. The ignition chamber of claim 2, wherein a length of the combustible gas pipeline is greater than a length of the combustion-supporting gas pipeline, an end of the combustible gas pipeline which is located outside the combustion-supporting gas pipeline is a closed end, and a portion of the combustible gas pipeline which is located outside the combustion-supporting gas pipeline is provided on a peripheral side with a combustible gas connecting pipe for connection to a combustible gas source.

4. The ignition chamber of claim 2, wherein the inner wall of the combustion chamber is provided with a combustible gas inlet and combustion-supporting gas inlets, the combustible gas inlet communicates the combustible gas pipeline with the interior of the combustion chamber, the combustion-supporting gas inlets communicate the interior of the combustion chamber with the combustion-supporting gas pipeline, a number of the combustion-supporting gas inlets is more than two, and the combustion-supporting gas inlets are disposed around the combustible gas inlet.

5. The ignition chamber of claim 4, wherein the combustible gas inlet and the combustion-supporting gas inlets are all located on a side of the inner wall of the combustion chamber away from the delivery pipeline.

6. The ignition chamber of any one of claims 1 to 5, wherein the combustion-supporting gas pipeline is located inside the diluent gas pipeline, and a diluent gas flow channel is formed between the diluent gas pipeline and the combustion-supporting gas pipeline, and communicates with the diluent gas channel.

7. The ignition chamber of claim 6, wherein a length of the combustion-supporting gas pipeline is greater than a length of the diluent gas pipeline, an end of the combustion-supporting gas pipeline which is located outside the diluent gas pipeline is a closed end, and a portion of the combustion-supporting gas pipeline which is located outside the diluent gas pipeline is provided on a peripheral side with a combustion-supporting gas connecting pipe for connection to a combustion-supporting gas source.

8. The ignition chamber of claim 7, wherein the diluent gas pipeline is provided with a diluent gas connecting pipe on a peripheral side away from the combustion chamber for connection to a diluent gas source.

9. The ignition chamber of any one of claims 1 to 5, wherein the outlet port is connected to an outlet pipe, the outlet pipe is located inside the delivery pipeline, an outer diameter of the outlet pipe is less than an inner diameter of the delivery pipeline, and a length of the outlet pipe is less than a length of the delivery line.

10. The ignition chamber of claim 9, wherein the inner diameter of the delivery pipeline is 1.5 to 2 times the outer diameter of the outlet pipe.

11. The ignition chamber of any one of claims 1 to 5, further comprising a heater and a thermal insulation device, wherein the thermal insulation device and the heater form a heating and insulation chamber together, and the chamber body is located in the heating and insulation chamber; and the heater is disposed at a connection where the combustible gas pipeline and the combustion-supporting gas pipeline are connected to the chamber body, and the combustible gas pipeline, the combustion-supporting gas pipeline, and the chamber body are partially located inside the heater.

12. A semiconductor process apparatus, comprising a process chamber and the ignition chamber of any one of claims 1 to 11, wherein the ignition chamber communicates with the process chamber through the delivery pipeline.
